# EUROPÄISCHE PATENTSCHRIFT

(11) **EP 2 313 788 B1**
(45) Veröffentlichungstag und Bekanntmachung des Hinweises auf die Patenterteilung: **09.08.2017**
(21) Anmeldenummer: 09779682.5
(22) Anmeldetag: 09.06.2009
(51) Int. Cl.: G01P 1/02, G01D 11/24, H01R 4/48, H01R 13/66, H03H 9/10, H05K 3/20, H05K 3/30, H05K 3/32

(54) **ELEKTRONISCHER SENSOR ODER SENSORGERÄT, INSBESONDERE BESCHLEUNIGUNGSSENSOR, MIT EINEM IN EIN SENSORGEHÄUSE EINGEBAUTEN CHIPMODUL**
ELECTRONIC SENSOR OR SENSOR DEVICE, IN PARTICULAR ACCELERATION SENSOR, COMPRISING A CHIP MODULE MOUNTED IN A SENSOR HOUSING
CAPTEUR OU APPAREIL DE DÉTECTION ÉLECTRONIQUE, EN PARTICULIER CAPTEUR D'ACCÉLÉRATION, COMPRENANT UN MODULE PUCE INTÉGRÉ À UN BOÎTIER DE CAPTEUR

(30) Priorität: 06.08.2008 DE 102008041035
(43) Veröffentlichungstag der Anmeldung: 27.04.2011
(73) Patentinhaber: Robert Bosch GmbH, 70442 Stuttgart (DE)
(72) Erfinder: LUDWIG, Ronny, 72411 Bodelshausen (DE)
(86) Internationale Anmeldenummer: PCT/EP2009/057083
(87) Internationale Veröffentlichungsnummer: WO 2010/015444

(56) Entgegenhaltungen:
- EP-A- 0 637 081
- DE-A1- 4 142 139
- DE-A1- 4 218 793
- DE-A1- 19 539 584
- DE-A1-102006 037 691
- DE-U1- 20 003 951
- FR-A- 2 748 105
- JP-A- H10 199 355
- US-A1- 2007 139 044
- MOTOROLA: "Micromachined Accelerometer Motorola MMA1201P"[Online] 2000, Seiten 1-8, XP002543909 Gefunden im Internet: URL:www.datasheetarchive.com/pdf-datasheet s/Datasheets-301/15724.pdf> [gefunden am 2009-09-02]

## Beschreibung

### Stand der Technik

Die Erfindung betrifft einen elektronischer Sensor oder Sensorgerät, insbesondere einen Beschleunigungssensor, mit einem Sensorgehäuse, in das ein Chipmodul eingebaut ist, wobei das Sensorgehäuse Steckerkontakte aufweist, die über elektrische Verbindungen mit Anschlüssen verbunden sind, die an einem Modulgehäuse des Chipmoduls angeordnet sind.

Ein derartiger Sensor, bei dem das Chipmodul ohne Substrat beziehungsweise Leiterplatte unmittelbar in das Sensorgehäuse eingebaut ist, ist bereits aus der DE 10 2006 037 691 A1 bekannt. Dabei ist es erforderlich, im Modulgehäuse selbst Einpresszonen und am Sensorgehäuse korrespondierende Einpresspins auszuformen.

Die am meisten verbreitete Art der Sensorherstellung ist jedoch - anders als beim genannten gattungsgemäßen Stand der Technik - die Montage eines SMD-fähigen Modulgehäuses (das sich im Design an einem Standard-Chipgehäuse, z.B. SOP, orientiert), welches den Sensorchip, den ASIC (Signalverarbeitungschip) und gegebenenfalls passive Bauelemente enthält, durch Standard-SMD-Prozesse auf einer Leiterplatte. Die bestückte Leiterplatte wird nachfolgend durch Bondprozesse oder Lötprozesse oder die kalte Kontaktiertechnik (Einpresstechnik, Schneidklemmen, etc.) in ein bereits vorher hergestelltes Plastikgehäuse mit metallischen Einlegeteilen montiert. Dieses Sensorgehäuse (Endgehäuse des Sensors) wird zum Schluss mit einem Deckel verschlossen (geklebt, Lasergeschweißt, etc.) oder mit einem Füllmaterial ausgegossen. Ein derartiges, zur Befestigung auf einem Substrat vorgesehenes Chipmodul ist z.B. aus der DE 10 2004 058 815 A1 bekannt. Bei diesen Konzepten ist demnach als Träger des Modulgehäuses und gegebenenfalls passiver Bauelemente eine Leiterplatte notwendig. Diese Technologie und die damit verbunden Montageprozesse bestimmen heute maßgeblich den Preis und die Marktfähigkeit eines Sensors, auch im Hinblick auf die kommende Entwicklung/Umstellung der Löttechnik auf bleifreie Lote und die damit verbundenen Entwicklungskosten.

Im Bereich der Modulgehäuse ist eine Vielzahl an Gehäusen und "Beinchenformen" bekannt. Insbesondere sind Dual-Inline-Gehäuse (DIP) als Modulgehäuse bekannt, allerdings nicht in ihrer ursprünglichen Form mit für die "Durchsteck-Montage" in metallisierten Leiterplattenbohrungen vorgesehenen Anschlusspins, sondern mit Anschlüssen, die für die heute übliche Oberflächenmontagetechnik (SMD) ausgelegt sind.

### Offenbarung der Erfindung

Der erfindungsgemäße elektronischer Sensor oder Sensorgerät ist in Anspruch 1 gekennzeichnet. Weiterbildungen und bevorzugte Maßnahmen ergeben sich aus den Unteransprüchen 2 bis 4. Das erfindungsgemäße Verfahren zur Herstellung eines derartigen Sensors ist in Anspruch 5 gekennzeichnet.

Hinsichtlich des elektrischen Sensors baut die Erfindung auf den gattungsgemäßen Merkmalen dadurch auf, dass das Modulgehäuse seitlich nach außen ragende Anschlusspins aufweist, die an ihren freien Enden jeweils eine Verjüngung aufweisen, und dass mindestens ein metallischer Trägerstreifen vorgesehen ist, der in einem ersten Endbereich als Steckerkontakt ausgebildet ist und in einem zweiten Endbereich für mindestens einen Anschlusspin jeweils eine Feder-Klemm-Kontaktstelle aufweist, die eine flexible Einpresszone für den korrespondierenden Anschlusspin bildet. In weiter erfindungsgemäßer Weise ist für die jeweils nicht zu kontaktierenden Anschlusspins mindestens eine Aussparung im Trägerstreifen vorgesehen.

Erfindungsgemäß gelingt damit die sichere elektrische und mechanische Integration eines mit Standardprozessen herstellbaren und genormten Modulgehäuses in ein kundenspezifisch herstellbares Kunststoffgehäuse. Erfindungsgemäß ist keine Verwendung von Blei im Sensor erforderlich. Die Erfindung beruht auf einem ganzheitlichen Sensorkonzept auf Basis eines minimal modifizierten Standard-Dual-Inline-Packages (DIP) mit vollständig integrierter Schaltungstechnik, welches in Einpresstechnik auf Federkontakt-Träger montiert und weiterverarbeitet wird. Aufgrund dieses Konzepts kommt die Erfindung ohne eine Leiterplatte oder ein Substrat aus, was zu einer Kostenreduktion führt. Kostenmäßig positiv wirkt sich weiterhin die Tatsache aus, dass erfindungsgemäß keine Änderung an der Matrix bekannter DIP-Leadframes erforderlich ist, somit die Fertigung mit Standardmaschinen und -werkzeugen möglich wird. Aufgrund der nur geringfügigen Änderungen an den Beinchen des DIP wird die Messtechnik bzw. der Abgleich mit Standard-Messaufnahmen ermöglicht, so dass keine teuren Sonderanfertigungen anfallen.

Ein besonderer Vorteil ergibt sich ferner aus der erfindungsgemäß gegebenen Variabilität hinsichtlich derjenigen Anschlusspins, deren Kontaktierung überhaupt erwünscht ist. Dazu werden nur die Beinchen eingepresst, die für die elektrische Funktion und die mechanische Festigkeit notwendig sind. Für alle anderen Anschlusspins werden im Trägerstreifen entsprechende Aussparungen vorgesehen.

Gemäß einer als besonders vorteilhaft angesehenen Ausführungsform der Erfindung ist der Trägerstreifen zur Bildung der Einpresszonen im zweiten Endbereich auf eine geringere Dicke als im ersten Endbereich heruntergeprägt. Erfindungsgemäß weisen die Einpresszonen jeweils einen quer zur Längsrichtung des Trägerstreifens angeordneten, zur Aufnahme des korrespondierenden Anschlusspins vorgesehenen Schlitz, sowie zwei Querstreben auf, wobei die Querstreben jeweils an eine der gegenüberliegenden Seiten des Schlitzes einerseits und an jeweils eine Aussparung im Trägerstreifen andererseits angrenzen. Die erforderliche Flexibilität der Einpresszonen lässt sich also durch einfache stanztechnische Maßnahmen realisieren.

Gemäß der Erfindung lässt sich der Trägerstreifen durch Wahl des Materials, seiner Dicke, sowie durch Wahl der Anordnung und Größe des Schlitzes und der Aussparungen so auslegen, dass beim Einpressen der Anschlusspins eine Federwirkung der Querstreben gegeben ist.

Als Modulgehäuse wird ein kostengünstiges Standard-Chipgehäuse, insbesondere ein Dual-Inline-Gehäuse (DIP) verwendet sofern es einsteckmontagefähige Anschlusspins aufweist, beziehungsweise sofern solche - beispielsweise durch Geradebiegen von SMD-fähigen, gebogenen Pins - erzeugt werden.

Ein erfindungsgemäßes Verfahren zur Herstellung eines Sensors oder Sensorgeräts sieht vor, dass das Modulgehäuse mittels Einpresstechnik auf den oder die metallischen Trägerstreifen montiert wird, und dass Modulgehäuse und Trägerstreifen anschließend durch gemeinsames Umspritzen mit Kunststoff in ein Sensorgehäuse eingebettet werden.

### Kurze Beschreibung der Zeichnungen

Die Erfindung wird nachfolgend anhand von Zeichnungen näher erläutert. Es zeigen:
- Figur 1: verschiedene Ansichten eines DIP-Modulgehäuses mit erfindungsgemäß modifizierten Anschlusspins,
- Figur 2: das in Figur 1 gezeigte Modulgehäuse im Matrix-Leadframe-Verbund vieler Modulgehäuse,
- Figur 3: eine Draufsicht und einen Querschnitt erfindungsgemäßer Trägerstreifen,
- Figur 4: die in Figur 3 gezeigten Trägerstreifen im Verband eines fortlaufenden Bandes,
- Figur 5: eine Draufsicht und einen Querschnitt eines erfindungsgemäß auf ^ zwei Trägerstreifen eingepressten Chipmoduls,
- Figur 6: eine Detaildarstellung zur Verdeutlichung der Einpresszonen des Trägerstreifens und des Einpressprozesses,
- Figur 7: eine Draufsicht und einen Querschnitt einer mit einem Zwischengehäuse umspritzten Anordnung gemäß Figur 5,
- Figur 8: verschiedene Ansichten des endgültigen Sensorgehäuses,
- Figur 9: weitere Darstellungen des endgültigen Sensorgehäuses,
- Figur 10 bis 12: verschiedene Stadien des erfindungsgemäßen Herstellungsprozesses des erfindungsgemäßen Sensors.

### Ausführungsform der Erfindung

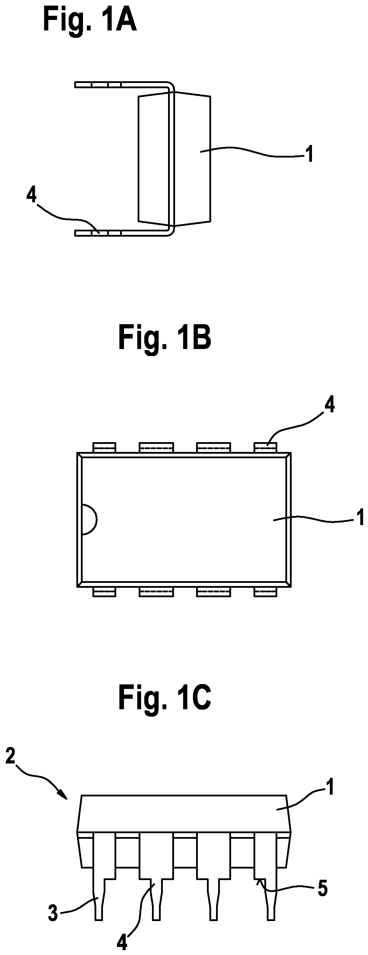

Figur 1 zeigt von der Stirnseite her (Figur 1A), in Draufsicht (Figur 1B) und von der Seite her (Figur 1C) die Darstellung eines nach JEDEC genormten Dual-Inline-Packages (DIP) mit jeweils vier aus den beiden Längskanten heraus ragenden Pins 4. Das Modulgehäuse 1 des Chipmoduls 2 wird in an sich bekannter Weise im Transfer-Moldverfahren hergestellt (Material: ein Moldcompound auf Basis eines Epoxys). Das Modulgehäuse 1 beinhaltet auf einem strukturierten Leadframe (Schaltungsträger) den mikrostrukturierten Sensorchip, den ASIC und passive Bauelemente (alles hier nicht dargestellt). Erfindungsgemäß wird als einzige Änderung die Form der Anschlusspins 4("Beinchen") leicht modifiziert. Die Modifikation umfasst mindestens eine Verjüngung 3 am freien Ende des jeweiligen Beinchens 4. Vorteilhaft ist ferner eine Anschlagsfläche 5. Basis des Chipmoduls 2 ist demnach - im dargestellten Ausführungsbeispiel - ein JEDEC-konformes Standard-Modulgehäuse 1 in Dual-Inline-Bauform, in welchem die vollständige Schaltung, also Schaltungsträger (strukturierter Leadframe), Sensorchip, ASIC und gegebenenfalls passive Bauelemente, integriert sind. Die Anschlussbeinchen 4 dieses erfindungsgemäßen Modulgehäuses 1 wurden jedoch durch eine Verjüngung 3 der Enden der Beinchen 4 schmäler gemacht. Außerdem wird der Übergang vom Beinchen 4 in das Gehäuse 1 - anders als beim ursprünglichen DIP - ohne Phase ausgelegt. Vielmehr ist eine Anschlagsfläche 5 pro Anschlusspin 4 vorgesehen.

Die Modifikation der Beinchen 4 beeinflusst vorteilhafterweise nicht das Rastermaß im Leadframe-Verbund, sowohl nicht in X-, als auch nicht in Y-Richtung. Auch die normalen Trenn-Biegewerkzeuge können verwendet werden. Somit ist die Darstellung innerhalb bekannter Matrix-Leadframestrukturen möglich sowie die Fertigung auf Standardmaschinen.

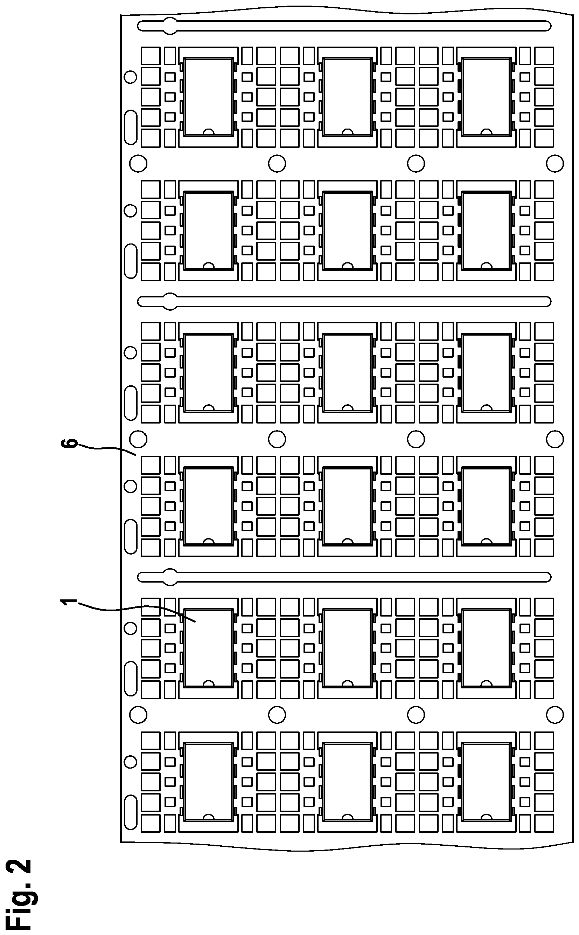

Figur 2 zeigt die Darstellung des in Figur 1 gezeigten DIP-Modulgehäuses 1 im Verbund vieler Modulgehäuse in Form eines Leadframes 6, genauer: den Ausschnitt eines Matrix-Leadframes. Da es sich quasi um ein Standard-Modulgehäuse 1 handelt, nur die Endform der "Beinchen" 4 leicht modifiziert wurde, ist die Herstellung auf Standardmaschinen in weltweit standardisierten Verfahren möglich, was zu einem erheblichen Kostenvorteil führt, da vorhandene Fertigungslinien, vorhandene Spitzguss- und Trenn-Biegewerkzeuge verwendet werden können.

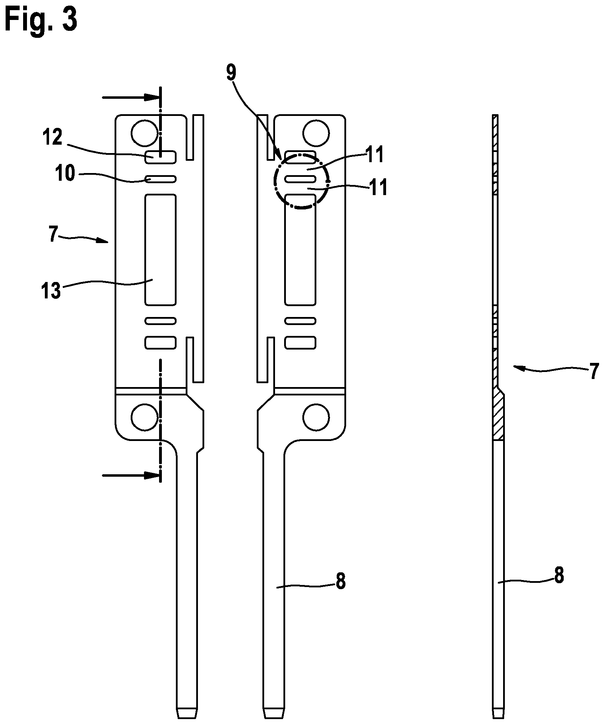

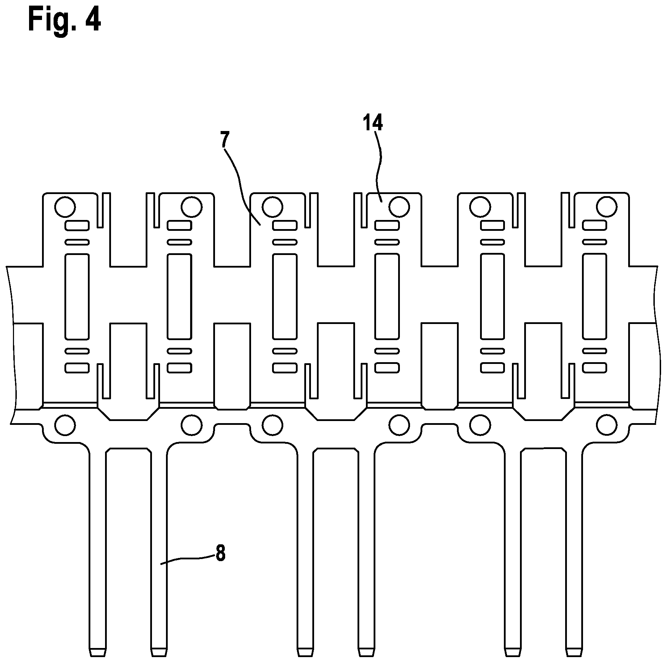

Figur 3 zeigt eine Darstellung des erfindungsgemäßen metallischen Trägerstreifens 7 in zwei Ansichten. (In der Draufsicht sind nebeneinander zwei Trägerstreifen dargestellt, die jeweils für die elektrische und mechanische Verbindung mit den an einer gemeinsamen Seite des DIP-Modulgehäuses 1 angeordneten Anschlusspins 4 verantwortlich sind.) Die Dicke des Trägerstreifens 7 wird durch die gewünschte Kundenschnittstelle definiert, in diesem Beispiel 0,6 mm Dicke des Steckerkontaktes 8. Das Rohband 14, vergleiche Figur 4, (z.B. aus CuSn₆) wird einseitig (hier im linken Endbereich der in Figur 3 dargestellten Trägerstreifen 7) auf die für die Kontaktierung zum DIP-Gehäuse 1 notwendige Dicke heruntergeprägt. In das heruntergeprägte Band 14 wird die Struktur der Klemm-Federkontakte 9 für die spätere Aufnahme des DIP-Gehäuses 1 eingestanzt und gegebenenfalls galvanisch beschichtet.

Der metallische Trägerstreifen 7 erfüllt erfindungsgemäß zwei Funktionen:
Zum einen die Realisierung der Steckerkontaktschnittstelle. Zum anderen die Möglichkeit, das DIP-Modulgehäuse 1 mittels Einpresstechnik (kalte Kontaktiertechnik) elektrisch zu kontaktieren und mechanisch sicher zu befestigen.

Die erste Funktion wird durch entsprechende Stanzwerkzeuge und durch die geeignete Wahl der Dicke des Trägerstreifens 7 gewährleistet. Für die zweite Funktion sind Federkontakt-Klemmstellen 9 vorgesehen. Im Prinzip wird hierbei die Standard-Einpresstechnik invertiert: Der Pin wird massiv und der Einpressbereich wird federnd bzw. klemmend ausgelegt. Die Pins sind erfindungsgemäß die Beinchen 4 des DIP-Modulgehäuses 1 und die Einpressbereiche 9 werden durch funktionsorientierte Auslegung des Trägerstreifens 7 dargestellt. Der Trägerstreifen 7 wird dazu auf das erforderliche Maß heruntergeprägt und durch eingestanzte Schlitze 10 werden Feder-Klemm-Kontaktstellen 9 in benötigter Anzahl realisiert. Dabei sind die Schlitze 10 durch mithilfe von Aussparungen 12 und 13 gebildete Querstreben 11 begrenzt.

Figur 4 zeigt eine Darstellung des erfindungsgemäßen Trägerstreifens 7 als Verbund in einem fortlaufenden Band 14(skizziert wurde nur ein kleiner Ausschnitt des Bandes 14). In Form eines Band 14 sind Bandgalvanik-Prozesse möglich, wie sie auch typischerweise bei Einpresskontakten vorgesehen werden. Die Vereinzelung der Trägerelemente 7 durch einen Stanzprozess erfolgt erst in der Endmontage. Da der Stanzprozess in einem Band 14 erfolgt, sind auch galvanisch aufgebrachte Oberflächen, auch partiell an den Steckerpins 8, das heißt anders als am Rest des Trägers 7, möglich, so dass die Bereiche des Trägerstreifens 7 mit zu ihren jeweiligen Funktionsumgebungen passenden Oberflächen versehen werden können.

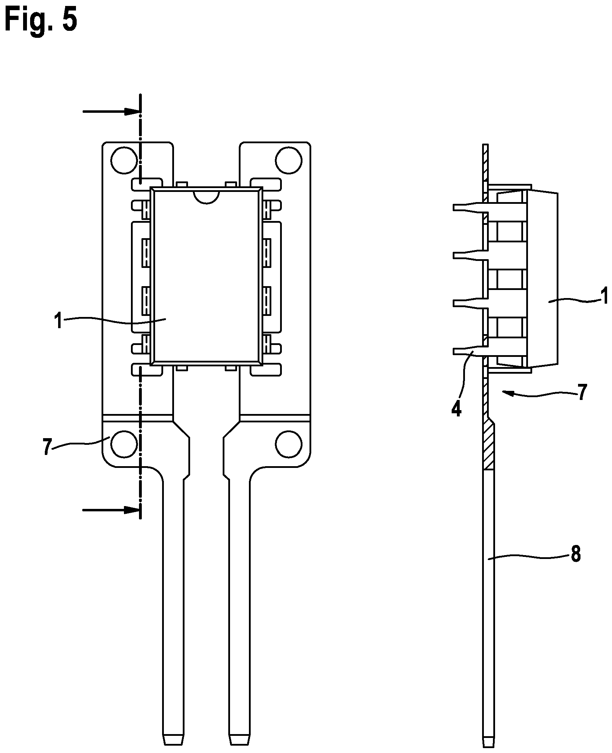

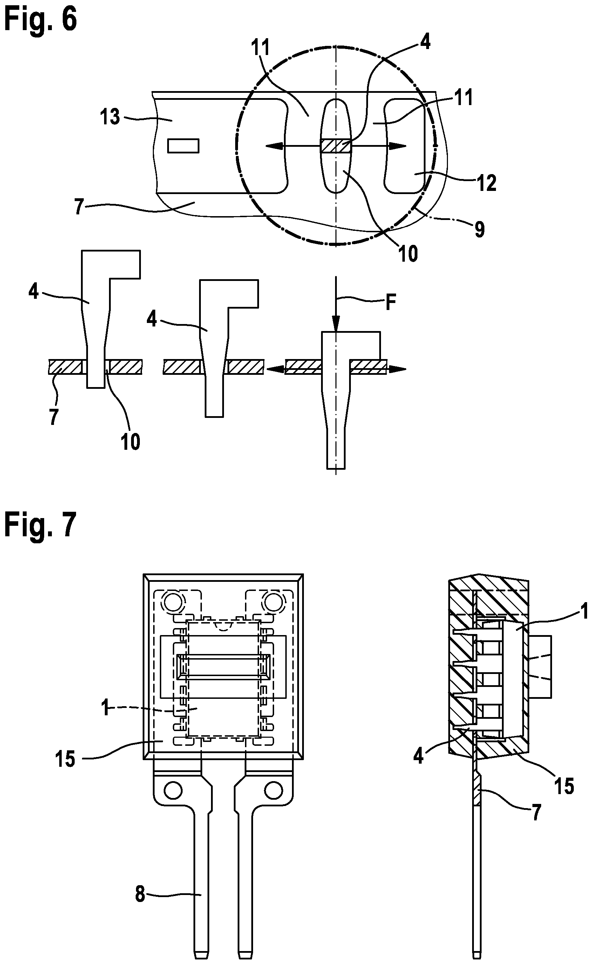

Figur 5 zeigt eine Darstellung des erfindungsgemäßen Aufbaus: Das DIP-Gehäuse 1 wird mittels Einpresstechnik (bzw. kalter Kontaktiertechnik) mit dem Trägerstreifen 7 verbunden. (zum genauen Ablauf vergleiche auch die Detaildarstellung gemäß Figur 6) Optional können am Trägerstreifen 7 seitliche Führungen zur Vorfixierung des DIP-Gehäuses 1 vorgesehen werden, welche durch einen Biegeprozess realisiert werden. Beispielhalber ist ein achtpoliges Modulgehäuse 1 dargestellt, so dass jedem Trägerstreifen 7 vier Anschlusspins 4 zugeordnet sind. Wie erkennbar, werden die beiden mittleren Anschlusspins 4 jeder Anschlussreihe nicht in Einpresszonen 9 kontaktiert, sondern erstrecken sich frei, das heißt, ohne elektrischen Kontakt beispielsweise durch die Aussparung 13 hindurch. Die zugehörigen, im normalen Betrieb des Sensors nicht zu kontaktierenden Anschlusspins 4 werden nur im Testbetrieb benötigt.

In Figur 6 ist erkennbar, wie bei einem konstruktiv und materialtechnisch entsprechend ausgelegtem Trägerstreifen 7 an den Feder-Klemm-Kontaktstellen 9 eine Feder-Klemmwirkung zu den Beinchen 4 des DIP-Gehäuses 4 durch den Einpressprozess entsteht. Zunächst wird das DIP-Beinchen 4 in einen Schlitz 10 des Trägerstreifens 7 eingefädelt. Das DIP-Beinchen 4 kommt beim weiteren Einpressen in Kontakt mit den Querstreben 11 und übt auf diese eine seitwärts gerichtete Kraft aus, der die Querstreben aufgrund ihrer Konstruktion beziehungsweise aufgrund der Aussparungen 12 und 13 teilweise federnd nachgeben können. Schließlich ist der jeweilige Anschlusspin 4 vollständig eingepresst und stellt eine sichere elektrische und mechanische Verbindung mit dem Trägerstreifen 7 her.

Die verjüngten Bereiche 3 der Beinchen 4 finden beim Bestücken gemäß den Figuren 5 und 6 in die dafür vorgesehenen Schlitze 10 im Trägerstreifen 7, da die Abmessungen der Beinchen 4 im verjüngten Bereich 3 geringfügig schmaler sind, als die Schlitze 10 breit sind. Durch Kraftbeaufschlagung werden die Beinchen 4 in die Schlitze 10 gedrückt. Die Klemmwirkung wird dadurch erzielt, da die Beinchen 4 im nicht verjüngten Bereich breiter sind als die Schlitze 10 im Träger 7. Der Träger 7 muss dabei eine gewisse Federwirkung der Querstreben 11 zulassen, was durch eine entsprechende Auslegung anhand der zur Verfügung stehenden Parameter ohne weiteres möglich ist.

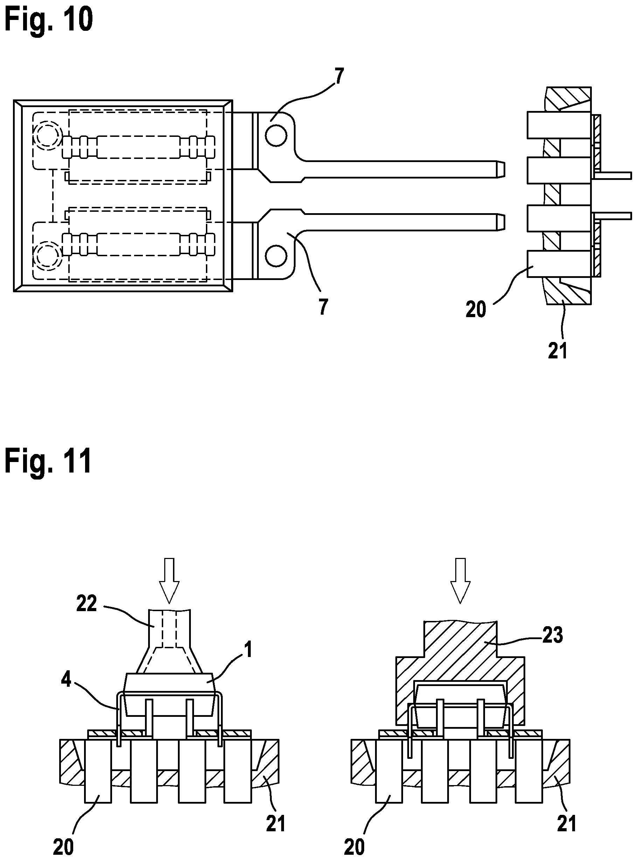

Um diese elektromechanische Verbindung zu sichern, wird der Trägerstreifen 7 mit einem Zwischengehäuse 15 umspritzt, vergleiche Figur 7. Zur mechanische Fixierung des eingepressten DIP-Gehäuses 1 auf dem Trägerstreifen 7 und zur Entkopplung des Stresses beim nachfolgenden Spritzgussprozess des umgebenden Sensorgehäuses (Endgehäuses) wird der gemäß Figur 5 vorliegende Aufbau mit einem umgebenden Zwischengehäuse 15, z.B. aus einem teilflexiblen Material (Silikon), umspritzt. Aus den in Figur 7 gewählten Darstellungen ist die nur beispielhafte Formgebung des Zwischengehäuses 15 erkennbar. Das für die Herstellung des Zwischengehäuses 15 erforderliche Spritzgusswerkzeug kann als Grundlage für den Einpressprozess dienen, indem "Schiebeelemente" die Abstützung der Krafteinkopplung übernehmen, vergleiche weiter unten Figur 10. Diese "Schiebeelemente" im Spritzgusswerkzeug können auch gleichzeitig die Funktion des Auswerfens des Zwischengehäuses 15 übernehmen. Außerdem ist das Zwischengehäuse 15 mit Hinsicht auf die Entkopplung des Stresses beim - mit sehr hohem Druck (>500 bar) erfolgenden - Umspritzen mit dem Kunststoff des Sensorgehäuses vorteilhaft.

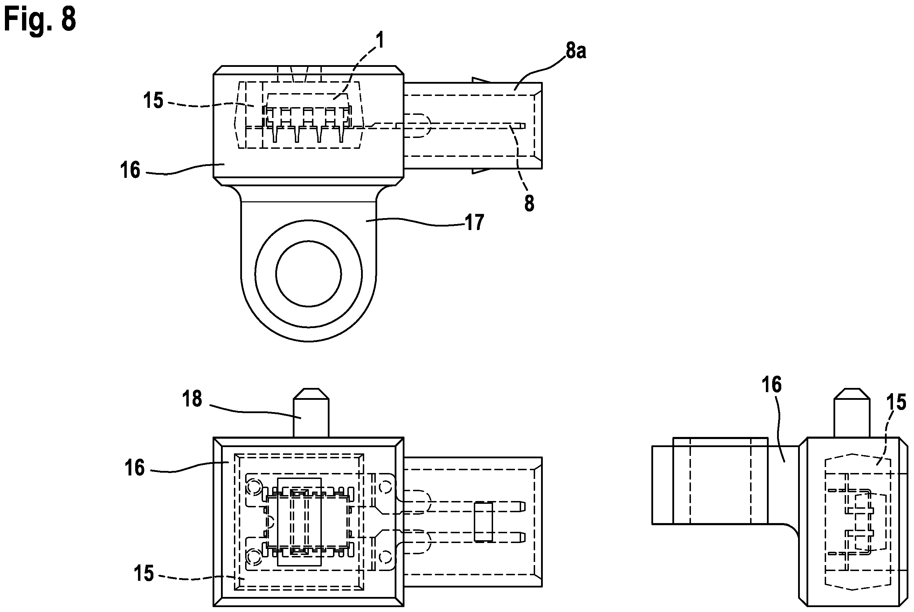

Zuletzt wird der Trägerstreifen 7 und das Zwischengehäuse 15 derart mit einem Kunststoff umspritzt, dass ein Endgehäuse (Sensorgehäuse) 16 entsteht, welche die Steckerschnittstelle 8a, vergleiche Figur 8, und eine Befestigungsmöglichkeit 17 beinhaltet.

Figur 8 zeigt eine Darstellung des endgültigen Sensorgehäuses 16, welches den zuvor beschriebenen Aufbau beinhaltet, in mehreren Ansichten und in "Durchsicht". Die Form ist beispielhaft gewählt und eignet sich insbesondere für einen Kfz-Beschleunigungssensor. Erkennbar ist ferner ein Montagepin 18.

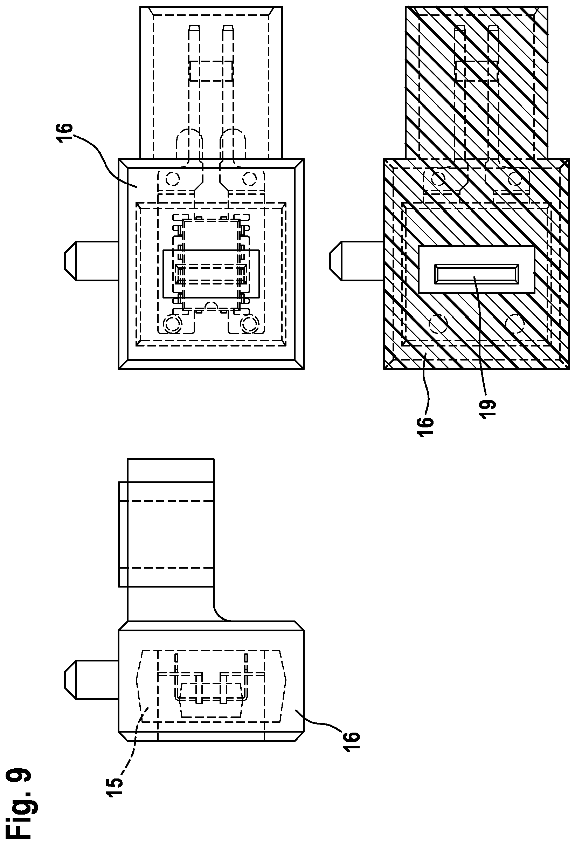

Figur 9 zeigt weitere Darstellungen des Endgehäuses 16 des Sensors. Um das Zwischengehäuse 15 im Spritzgusswerkzeug des Endgehäuses 16 fixieren zu können, ist im dargestellten Ausführungsbeispiel an der Oberseite des Zwischengehäuses 15 ein "Aufsatz mit zentraler Vertiefung" 19 vorgesehen. Der Gegenpart dazu befindet sich im (nicht dargestellten) Spritzgusswerkzeug und unterstützt die exakte Positionierung des Zwischengehäuses 15 zum Endgehäuse 16. Der Anspritzpunkt des Endgehäuses 16 wird so gewählt (z.B. unterhalb der Buchse), dass die einspritzende Kunststoffmasse das Zwischengehäuse 15 genau gegen diese Aufnahmefläche 19 drückt.

Figur 10 bis 12 zeigt die Darstellung verschiedener Stadien eines möglichen Prozessablaufes bei der Herstellung:
Gemäß Figur 10 werden zunächst die freigestanzten Trägerelemente 7 über der unteren, für die Herstellung des Zwischengehäuses 15 bereitgestellten, Spritzgusskavität 21 positioniert. In der Kavität 21 befinden sich Schiebeelemente 20, welche auf die Höhe des Trägerstreifens 7 ausgefahren sind.

Durch einen Pick & Place Prozess wird mittels Vakuumsauger 22 das DIP-Gehäuse 1, vergleiche Figur 11, linker Teil, zum Trägerstreifen 7 positioniert und bestückt (eingefädelt).

Ein Einpresswerkzeug 23, vergleiche Figur 11, rechter Teil, presst das Gehäuse 1 bzw. die DIP-Beinchen 4 in die Federelemente 9 des Trägerstreifens 7 ein. Beim Einpressvorgang sind die "Schieber" 20 im Spritzgusswerkzeug 21 gleichzeitig die "Gegenlager" für die (von oben her) eingebrachte Einpresskraft.

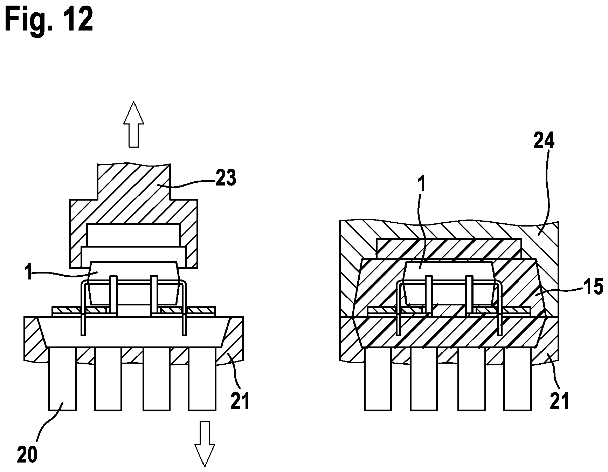

Das Einpresswerkzeug 23 und die zur Kraftaufnahme notwendigen Schieber 20 werden anschließend zurück gefahren, vergleiche Figur 12, linker Teil, die obere Spritzgusskavität 24 schließt dann das zur Herstellung des Zwischengehäuses 15 vorgesehene Spritzwerkzeug, vergleiche Figur 12, rechter Teil.

Nach dem Einspritzen der Masse und Abkühlen ist das Zwischengehäuse 15 fertig. Die Schieber 20 dienen hier gleichzeitig als "Auswerfer" des Zwischengehäuses 15 aus der unteren Spritzgusskavität 21.

Zum Schluss erfolgt das Umspritzen des umschließenden Endgehäuses 16 mit dem in den Figuren 8 und 9 dargestellten Ergebnis, welches die Steckerschnittstelle 8a und die Anschraub- bzw. Montagemöglichkeit 17 und 18 vorsieht.

Im Folgenden sollen zusammenfassend nochmals einige wesentliche Vorteile der Erfindung genannt werden:
Ermöglicht wird eine ideale Stressentkopplung zwischen DIP-Modulgehäuse 1 und Trägerstreifen 7 aufgrund der Beinchenlänge am DIP-Gehäuse 1. Andererseits ergibt sich eine sehr kleine Sensorgröße des gesamten Sensors. Die Montageprozesse werden insgesamt stark reduziert. Da keine thermischen Montage- bzw. Verbindungsprozesse, kein Schweißen, Löten usw. erforderlich ist, ergibt sich somit kein thermischer Stress auf das DIP-Modulgehäuse durch die Verbindungstechnik. Da die Gehäuseformen kaum eingeschränkt sind, sind insbesondere auch Kfz taugliche Sensorgehäuse realisierbar.

Ferner resultiert eine Entschärfung der so genannten "Partikelproblematik" elektrisch leitfähiger Partikel. Eine Kontamination durch Lotkugeln, Flussmittelrückstande, Schmauchspuren beim Schweißen, Kleberrückstände beim Silberleitkleben, etc ist aufgrund der erfindungsgemäßen Montage nicht zu befürchten.

Bei Verwendung eines Transfer-Moldverfahren (d.h. wenn das Endgehäuse 16 aus Moldcompound / Epoxy hergestellt wird) kann gegebenenfalls auf das Zwischengehäuse 15 verzichtet werden.

Mit ein und dem gleichen DIP-Modulgehäuse 1 sind bei vielen Sensortypen sämtliche Sensierungsrichtungen einfach nur durch Variation der Lage des Trägerstreifens (0°-, 45°-, 90°-Sensor, usw.) realisierbar.

## Patentansprüche

1. Elektronischer Sensor oder Sensorgerät, insbesondere Beschleunigungssensor, mit einem Sensorgehäuse (16), in das ein Chipmodul (2) eingebaut ist, wobei das Sensorgehäuse (16) Steckerkontakte (8) aufweist, die über elektrische Verbindungen mit Anschlüssen verbunden sind, die an einem Modulgehäuse (1) des Chipmoduls (2) angeordnet sind, **dadurch gekennzeichnet, dass**
- das Modulgehäuse (1) ein Standard-Chipgehäuse, insbesondere ein Dual-Inline-Gehäuse DIP ist, das seitlich nach außen ragende, einsteckmontagefähige Anschlusspins (4) aufweist, die an ihren freien Enden jeweils eine Verjüngung (3) aufweisen,
- dass mindestens ein metallischer Trägerstreifen (7) vorgesehen ist, der in einem ersten Endbereich als Steckerkontakt (8) ausgebildet ist und in einem zweiten Endbereich für mindestens einen Anschlusspin (4) jeweils eine Feder-Klemm-Kontaktstelle (9) aufweist, die eine flexible Einpresszone für den korrespondierenden Anschlusspin (4) bildet,
- wobei das Modulgehäuse (1) wenigstens einen kontaktierten und wenigstens einen nicht kontaktierten Anschlusspin (4) aufweist,
- wobei für die jeweils nicht zu kontaktierenden Anschlusspins (4) mindestens eine Aussparung (12, 13) im Trägerstreifen (7) vorgesehen ist,
- wobei Modulgehäuse (1) und Trägerstreifen (7) in das Sensorgehäuse (16) eingebettet sind,
- wobei die Einpresszonen jeweils einen quer zur Längsrichtung des Trägerstreifens (7) angeordneten, zur Aufnahme des korrespondierenden Anschlusspins (4) vorgesehenen Schlitz (10), sowie zwei Querstreben (11) aufweisen, wobei die Querstreben (11) jeweils an eine der gegenüberliegenden Seiten des Schlitzes (10) einerseits und an jeweils eine Aussparung (12, 13) im Trägerstreifen (7) andererseits angrenzen, und wobei der Trägerstreifen (7) hinsichtlich Material, Dicke, Anordnung und Größe des Schlitzes (10) und der Aussparungen (12,13) so ausgelegt ist, dass beim Einpressen der Anschlusspins (4) durch eine seitwärts gerichtete Kraft eine Federwirkung der Querstreben (11) auf den nicht verjüngten Bereich der Anschlusspins (4) erzielt wird.

2. Elektronischer Sensor oder Sensorgerät nach Anspruch 1, **dadurch gekennzeichnet, dass** zur Bildung der Einpresszonen der Trägerstreifen (7) im zweiten Endbereich auf eine geringere Dicke als im ersten Endbereich heruntergeprägt ist.

3. Elektronischer Sensor oder Sensorgerät nach Anspruch 1, **dadurch gekennzeichnet, dass** die Anschlusspins (4) zwischen der Verjüngung (3) und dem Übergang in das Modulgehäuse (1) jeweils mindestens eine Anschlagfläche (5) oder Schulter aufweisen, die bei eingepresstem Anschlusspin (4) auf dem Trägerstreifen (7) aufsitzt.

4. Elektronischer Sensor oder Sensorgerät nach einem der Ansprüche 1 bis 3, **dadurch gekennzeichnet, dass** der zweite Endbereich des Trägerstreifens (7) zusammen mit dem mit ihm in Einpresstechnik verbundenen Chipmodul (2) mit einem Zwischengehäuse (15) umspritzt ist, das in das Sensorgehäuse (16) eingebaut ist.

5. Verfahren zur Herstellung eines elektronischer Sensors oder Sensorgeräts nach einem der Ansprüche 1 bis 4, **dadurch gekennzeichnet, dass** seitlich aus dem Modulgehäuse (1) in Form eines Standard-Chipgehäuses, insbesondere eines Dual-Inline-Gehäuses DIP, nach außen ragende und zu kontaktierende Anschlusspins (4) mit einer Verjüngung an ihrem freien Ende mittels Einpresstechnik in jeweils eine Feder-Klemm-Kontaktstelle (9) auf mindestens einem metallischen Trägerstreifen (7) montiert werden, wobei die jeweilige Feder-Klemm-Kontaktstelle (9) eine flexible Einpresszone für den korrespondierenden Anschlusspin (4) bildet und wobei die Einpresszonen jeweils einen quer zur Längsrichtung des Trägerstreifens (7) angeordneten, zur Aufnahme des korrespondierenden Anschlusspins (4) vorgesehenen Schlitz (10), sowie zwei Querstreben (11) aufweisen, wobei die Querstreben (11) jeweils an eine der gegenüberliegenden Seiten des Schlitzes (10) einerseits und an jeweils eine Aussparung (12, 13) im Trägerstreifen (7) andererseits angrenzen, wobei der Trägerstreifen (7) hinsichtlich Material, Dicke, Anordnung und Größe des Schlitzes (10) und der Aussparungen (12,13) so ausgelegt ist, dass die im nicht verjüngten Bereich breiter als der Schlitz ausgebildeten Anschlusspins (4) beim Einpressen eine seitwärts gerichtete Kraft auf die Querstreben (11) ausüben, welcher diese teilweise federnd nachgeben können, und dass Modulgehäuse (1) und Trägerstreifen (7) anschließend durch Umspritzen mit Kunststoff in ein Sensorgehäuse (16) eingebettet werden.

6. Verfahren nach Anspruch 5, **dadurch gekennzeichnet, dass** ein fortlaufendes Band (14) bereitgestellt wird, das mehrere Trägerstreifen (7) als Verbund aufweist, und dass anschließend eine Vereinzelung der Trägerstreifen (7) durch einen Stanzprozess und daraufhin jeweils die Montage des Modulgehäuses (1) auf den Trägerstreifen (7) erfolgt.

7. Verfahren nach Anspruch 6, **dadurch gekennzeichnet, dass** durch mindestens einen Bandgalvanik-Prozess an den Trägerstreifen (7) oder Teilen davon galvanisch aufgebrachte Oberflächen erzeugt werden.

8. Verfahren nach Anspruch 6 oder 7, mit mindestens folgenden Schritten:
- Positionieren der freigestanzten Trägerstreifen (7) über einer zur Herstellung eines Zwischengehäuses (15) vorgesehenen unteren Spritzgusskavität (21) eines Spritzwerkzeugs, wobei in der Kavität (21) Schiebeelemente (20) vorgesehen sind, welche auf die Höhe des Trägerstreifens (7) ausgefahren sind,
- Positionieren, Bestücken und anschließendes Einpressen des Modulgehäuses (1) mittels eines Einpresswerkzeugs (23) in den Trägerstreifen (7), wobei die Krafteinkopplung durch die Schiebeelemente (20) abgestützt wird,
- Zurückfahren des Einpresswerkzeugs (23) und der Schiebeelemente (20), sowie Schließen der oberen Spritzgusskavität (24) des Spritzwerkzeugs,
- Herstellen des Zwischengehäuses (15) durch Umspritzen mit Kunststoff,
- Herstellen des Sensorgehäuses (16) durch Umspritzen des Zwischengehäuses (15) und der Steckerkontakte (8) des Trägerstreifens (7) mithilfe einer weiteren Spritzgussform.

## Claims

1. Electronic sensor or sensor device, in particular acceleration sensor, having a sensor housing (16) in which a chip module (2) is incorporated, the sensor housing (16) having plug contacts (8) which are connected via electrical connections to terminals which are arranged on a module housing (1) of the chip module (2), **characterized in that**
- the module housing (1) is a standard chip housing, in particular a dual-in-line housing DIP, which has terminal pins (4) which project laterally outwards and are capable of being mounted by pressing in, and which at their free ends each have a taper (3),
- **in that** at least one metallic bearer strip (7) is provided, which is formed as a plug contact (8) in a first end region and, in a second end region, has a spring clamping contact point (9) for at least one terminal pin (4) in each case, which spring clamping contact point forms a flexible press-in zone for the corresponding terminal pin (4),
- wherein the module housing (1) has at least one contacted and at least one non-contacted terminal pin (4),
- wherein at least one cut-out (12, 13) in the bearer strip (7) is provided for the respective terminal pin (4) that is not to be contacted,
- wherein module housing (1) and bearer strip (7) are embedded in the sensor housing (16),
- wherein the press-in zones each have a slot (10) arranged transversely with respect to the longitudinal direction of the bearer strip (7) and provided to receive the corresponding terminal pin (4), and two cross-struts (11), wherein the cross-struts (11) each adjoin one of the opposite sides of the slot (10) on the one side and each adjoin a cut-out (12, 13) in the bearer strip (7) on the other side, and wherein the bearer strip (7) is designed with regard to material, thickness, arrangement and size of the slot (10) and the cut-outs (12, 13) such that, when the terminal pin (4) is pressed in by a laterally directed force, a spring action of the cross-struts (11) on the non-tapered region of the terminal pin (4) is achieved.

2. Electronic sensor or sensor device according to Claim 1, **characterized in that**, in order to form the press-in zones, the bearer strip (7) is stamped down in the second end region to a lower thickness than in the first end region.

3. Electronic sensor or sensor device according to Claim 1, **characterized in that** the terminal pins (4) between the taper (3) and the transition to the module housing (1) each have at least one stop surface (5) or shoulder, which is seated on the bearer strip (7) when the terminal pin (4) is pressed in.

4. Electronic sensor or sensor device according to one of Claims 1 to 3, **characterized in that** the second end region of the bearer strip (7), together with the chip module (2) connected thereto by a press-in technique, is over-moulded with an intermediate housing (15), which is incorporated into the sensor housing (16).

5. Method for producing an electronic sensor or sensor device according to one of Claims 1 to 4, **characterized in that** terminal pins (4) projecting laterally outwards from the module housing (1) in the form of a standard chip housing, in particular a dual-in-line housing DIP, and with which contact is to be made are mounted with a taper at their free end by means of a press-in technique in each case in one spring clamping contact point (9) on at least one metallic bearer strip (7), wherein the respective spring clamping contact point (9) forms a flexible press-in zone for the corresponding terminal pin (4), and wherein the press-in zones each have a slot (10) arranged transversely with respect to the longitudinal direction of the bearer strip (7) and provided to receive the corresponding terminal pin (4), and two cross-struts (11), wherein the -cross-struts (11) each adjoin one of the opposite sides of the slot (10) on one side and each adjoin a cut-out (12, 13) in the bearer strip (7) on the other side, wherein the bearer strip (7) is designed with regard to material, thickness, arrangement and size of the slot (10) and the cut-outs (12, 13) such that the terminal pins (4) formed to be wider than the slot in the non-tapered region exert a laterally directed force on the cross-struts (11) as they are pressed in, to which the latter can partly give way in a sprung manner, and **in that** module housing (1) and bearer strip (7) are then embedded in a sensor housing (16) by over-moulding with plastic.

6. Method according to Claim 5, **characterized in that** a continuous strip (14) is provided, which has a plurality of bearer strips (7) as a composite, and **in that** individualization of the bearer strips (7) by a punching process and then the respective mounting of the module housing (1) on the bearer strip (7) are then carried out.

7. Method according to Claim 6, **characterized in that**, by means of at least one strip galvanizing process, galvanically applied surfaces are produced on the bearer strip (7) or parts thereof.

8. Method according to Claim 6 or 7, having at least the following steps:
- positioning the punched-out bearer strips (7) over a lower injection moulding cavity (21), provided for the production of an intermediate housing (15), of an injection mould, wherein sliding elements (20) which are extended to the height of the bearer strip (7) are provided in the cavity (21),
- positioning, populating and subsequently pressing the module housing (1) into the bearer strip (7) by means of a press-in tool (23), wherein the introduction of force is supported by the sliding elements (20),
- retracting the press-in tool (23) and the sliding elements (20), and closing the upper injection moulding cavity (24) of the injection mould,
- producing the intermediate housing (15) by over-moulding with plastic,
- producing the sensor housing (16) by over-moulding the intermediate housing (15) and the plug contacts (8) of the bearer strip (7) with the aid of a further injection mould.

## Revendications

1. Capteur ou appareil de détection électronique, en particulier un capteur d'accélération, comprenant un boîtier de capteur (16) auquel est intégré un module de puce (2), dans lequel le boîtier de capteur (16) comporte des contacts enfichables (8) qui sont reliés par l'intermédiaire de liaisons électriques à des bornes disposées sur un boîtier de module (1) du module de puce (2), **caractérisé en ce que**
- le boîtier de module (1) est un boîtier de puce standard, en particulier un boîtier en ligne double de type DIP, qui présente des broches de connexion (4) adaptées à un montage enfichable, faisant saillie latéralement vers l'extérieur, qui présentent respectivement à leurs extrémités libres un rétrécissement (3),
- **en ce qu'**il est prévu au moins un ruban de support (7) métallique qui est réalisé sous la forme d'un contact enfichable (8) dans une première zone d'extrémité et qui présente respectivement dans une deuxième zone d'extrémité, pour au moins une broche de connexion (4), un point de contact de borne à ressort (9) formant une zone à enfoncer flexible pour la broche de connexion (4) correspondante,
- dans lequel le boîtier de module (1) comporte au moins une broche de connexion (4) présentant un contact et au moins une broche de connexion sans contact,
- dans lequel, pour la broche de connexion (4) respective sans contact, il est prévu au moins un évidement (12, 13) dans le ruban de support (7),
- dans lequel le boîtier de module (1) et le ruban de support (7) sont intégrés au boîtier de capteur (16),
- dans lequel les zones à enfoncer comportent une fente (10) respective disposée transversalement à la direction longitudinale du ruban de support (7) pour recevoir la broche de connexion (4) correspondante, ainsi que deux traverses (11), dans lequel les traverses (11) sont respectivement adjacentes d'une part, à l'une des faces opposées de la fente (10), et d'autre part, à un évidement (12, 13) respectif ménagé dans le ruban de support (7), et dans lequel le ruban de support (7) est conçu, du point de vue du matériau, de l'épaisseur, de l'agencement et de la taille de la fente (10) et des évidements (12, 13), de manière à ce que, lors de l'insertion des broches de connexion (4) au moyen d'une force orientée latéralement, un effet de ressort des traverses (11) soit obtenu sur la zone non rétrécie de la broche de connexion (4).

2. Capteur ou appareil de détection électronique selon la revendication 1, **caractérisé en ce que** le ruban de support (7) est estampé par le dessous dans la deuxième zone d'extrémité sur une plus faible épaisseur que dans la première zone d'extrémité pour former les zones à enfoncer.

3. Capteur ou appareil de détection électronique selon la revendication 1, **caractérisé en ce que** les broches de connexion (4) comportent respectivement, entre le rétrécissement (3) et la transition vers le boîtier de module (1), au moins une surface de butée (5) ou un épaulement qui repose sur le ruban de support (7) lorsque la broche de connexion (4) est enfoncée.

4. Capteur ou appareil de détection électronique selon l'une quelconque des revendications 1 à 3, **caractérisé en ce que** la deuxième zone d'extrémité du ruban de support (7) est enrobée en association avec le module de puce (2) qui lui est relié par une opération d'insertion avec un boîtier intermédiaire (15) qui est intégré au boîtier de capteur (16).

5. Procédé de fabrication d'un capteur ou d'un appareil de détection électronique selon l'une quelconque des revendications 1 à 4, **caractérisé en ce que** des broches de connexion (4) faisant saillie latéralement vers l'extérieur du boîtier de module (1) sous la forme d'un boîtier de puce standard, en particulier d'un boîtier double en ligne de type DIP, et comportant un rétrécissement à leur extrémité libre, sont montées par une opération d'enfoncement en un point de contact de borne à ressort (9) respectif sur au moins un ruban de support (7) métallique, dans lequel le point de contact de borne à ressort (9) respectif forme une zone à enfoncer flexible pour la broche de connexion (4) correspondante et dans lequel les zones à enfoncer comportent respectivement une fente (10) disposée transversalement à la direction longitudinale du ruban de support (7) et prévue pour recevoir la broche de connexion (4) correspondante, ainsi que deux traverses (11), dans lequel les traverses (11) sont adjacentes, d'une part, à l'un des côtés opposés de la fente (10) et, d'autre part, à un évidement (12, 13) respectif ménagé dans le ruban de support (7), dans lequel le ruban de support (7) est conçu, du point de vue du matériau, de l'épaisseur, de l'agencement et de la taille de la fente (10) et des évidements (12, 13), de manière à ce que les broches de connexion (4) réalisées de manière à être plus larges dans la zone non rétrécie que la fente lors de l'insertion, exercent une force orientée latéralement sur les traverses (11), lesquelles traverses peuvent restituer de manière partiellement élastique ladite force, et **en ce que** le boîtier de module (1) et le ruban de support (7) sont ensuite intégrés par enrobage par une matière plastique dans le boîtier de capteur (16).

6. Procédé selon la revendication 5, **caractérisé en ce qu'**il est prévu une bande (14) continue qui comporte plusieurs rubans de support (7) sous la forme d'un composite, et **en ce qu'**une séparation des rubans de support (7) est ensuite effectuée par un processus d'estampage et **en ce que** le montage du boîtier de module (1) est ensuite effectué sur le ruban de support (7).

7. Procédé selon la revendication 6, **caractérisé en ce que** des surfaces déposées de manière galvanique sont produites au moyen d'au moins un processus de galvanisation par bande sur le ruban de support (7) ou des parties de celui-ci.

8. Procédé selon la revendication 6 ou 7, comportant au moins les étapes consistant à :
- positionner les rubans de support (7) découpés sur une cavité de moulage par injection (21) inférieure prévue pour la fabrication d'un boîtier intermédiaire (15), d'un outil de moulage par injection, dans lequel il est prévu dans la cavité (21) des éléments coulissants (20) qui sont sortis sur la hauteur du ruban de support (7),
- positionner, équiper, puis enfoncer le module de boîtier (1) au moyen d'un outil d'insertion (23) dans le ruban de support (7), dans lequel l'application des forces est accompagnée par les éléments coulissants (20),
- rétracter l'outil d'insertion (23) et les éléments coulissants (20) et refermer la cavité de moulage par injection (25) supérieure de l'outil de moulage par injection,
- fabriquer le boîtier intermédiaire (15) par enrobage de matière plastique,
- fabriquer le boîtier de capteur (16) par enrobage du boîtier intermédiaire (15) et du contact enfichable (8) du ruban de support (7) à l'aide d'un autre moule de moulage par injection.
